# EUROPEAN PATENT SPECIFICATION

(11) **EP 0 389 718 B1**
(45) Date of publication and mention of the grant of the patent: **08.03.1995**
(21) Application number: 89312538.5
(22) Date of filing: 01.12.1989
(51) Int. Cl.: H01L 21/205, C30B 25/02, C30B 25/14

(54) **A method of crystal growing a semiconductor thin film and an apparatus therefor**
Verfahren zum Züchten einer kristallinen halbleitenden Dünnschicht und Vorrichtung dafür
Méthode de croissance d'un film mince semi-conducteur cristallin et appareil pour cela

(30) Priority: 30.03.1989 JP 80482/89
(43) Date of publication of application: 03.10.1990
(73) Proprietor: MITSUBISHI DENKI KABUSHIKI KAISHA, Tokyo (JP)
(72) Inventor: Yagi, Tetsuya Mitsubishi Denki K.K., Itami-shi Hyogo-ken (JP)
(74) Representative: Beresford, Keith Denis Lewis

(56) References cited:
- DE-A- 3 635 279
- GB-A- 2 198 454
- JAPANESE JOURNAL OF APPLIED PHYSICS/PART 2: LETTERS, vol. 26, no. 3, March 1987, pages L200-L202; K. KIMURA et al.: "Doping enhancement by excimer laser irradiation in gas source molecular beam epitaxy of GaAs"
- JAPANESE JOURNAL OF APPLIED PHYSICS, vol. 26, no. 7, part I, July 1987, pages 1077-1081; F. KOYAMA et al.: "GaAlAs/GaAs MOCVD growth for surface emitting laser"
- PATENT ABSTRACTS OF JAPAN, vol. 8, no. 243 (E-277)[1680], 8th November 1984 & JP-A-59 121 917

## Description

### METHOD OF THE INVENTION

The present invention relates to a method of crystal growing a semiconductor thin film and an apparatus therefor, and more particularly to those utilizing metal organic chemical vapor deposition method.

### BACKGROUND OF THE INVENTION

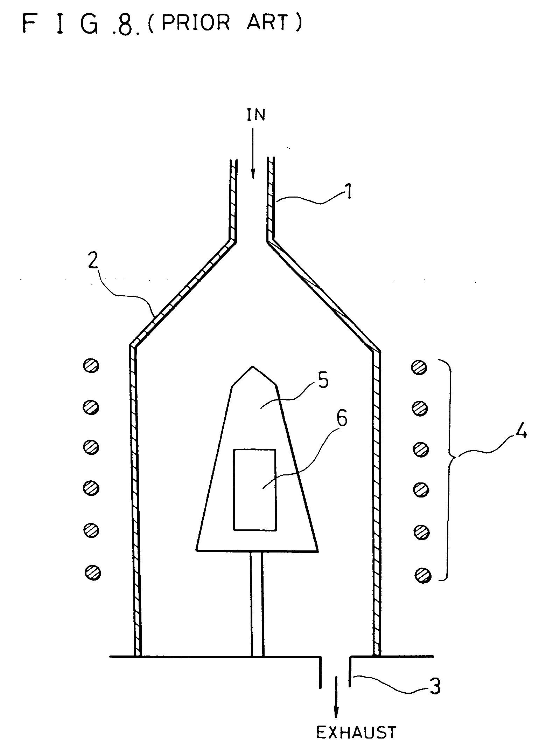

Figure 8 is a schematic view showing the periphery of reaction tube of a prior art apparatus which is used for metal organic chemical vapor deposition (hereinafter referred to as "MOCVD") utilizing thermal decomposition. In figure 8, reference numeral 2 designates a reaction tube made of quartz having a material gas inlet 1 at the top portion thereof. An exhaust gas outlet 3 is provided at the bottom of reaction tube 2. Coils 4 for heating a carbon wafer susceptor 5 by high frequency electric wave are provided outside the reaction tube 2 with surrounding the same. The carbon wafer susceptor 5 is provided inside the reaction tube 2. A wafer 6 is put on the susceptor 5.

A method of growing an AlGaAs epitaxy layer utilizing this prior art apparatus will be described.

When an AlGaAs layer is epitaxy grown, GaAs is generally used as a substrate, and trimethyl-gallium (TMGa), trimethyl-aluminum (TMAl), and arsine (AsH₃) are used for the materials. Although there are various kinds of doping materials, hydrogen selenide (H₂Se) is generally used for donor material and dimethyl-zinc (DMZn) or diethyl zinc (DEZn) is generally used for acceptor material. These materials are introduced into the reaction tube 2 from the material gas inlet 1 together with the hydrogen as carrier gas. The materials introduced into the reaction tube 2 are decomposed at places on or near the GaAs substrate 6 which is put on the wafer susceptor 5 which is induction heated by the high frequency heating coils 4. Simply to say, an AlGaAs epitaxy layer is grown on the GaAs substrate 6 on the basis of the reaction in accordance with the following formula. ${\text{xTMAl + (1 - x)TMGa + AsH₃ → Al}}_{\text{x}} {\text{Ga}}_{\text{1-x}} \text{As + 3CH₄}$
That is, the mixed crystal of epitaxy layer can be controlled by varying the composition ratio of material gas. The conductivity type and the carrier concentration of epitaxy layer can be controlled by mixing doping material into the material gas. Since the above-described doping materials such as H₂Se, DMZn, or DEZn have quite a high decomposition speed at the epitaxy growth temperature within 600 to 750 °C employed in ordinary MOCVD method, the carrier concentration of doped epitaxy layer is regulated by its transportation speed. That is, the carrier concentration of epitaxy layer can be controlled by the flow rate of doping gas in the material gas. The upper limitation value is regulated by the dopant solubility in the epitaxy layer solid phase.

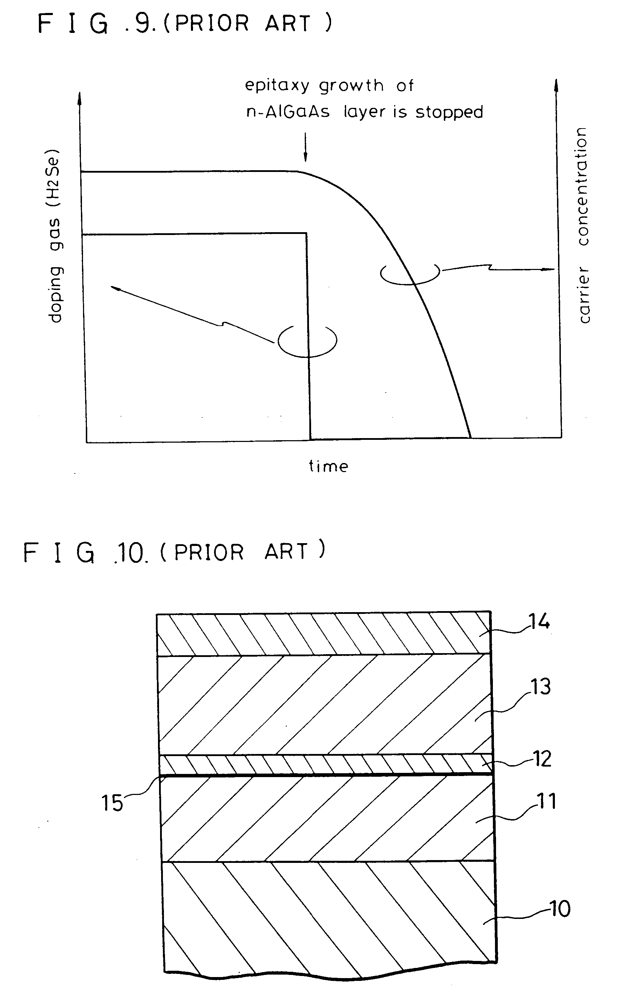

When an n type AlₓGa₁₋ₓAs (hereinafter referred to as "n-AlₓGa₁₋ₓAs") epitaxy layer is grown on the substrate and an undoped or a p type Al_{y}Ga_{1-y}As (hereinafter referred to as "p-Al_{y}Ga_{1-y}As") epitaxy layer is grown thereon with using H₂Se as n type dopant with using the apparatus of figure 8, the supply of H₂Se into reaction tube 2 is halted when the growth of n-AlₓGa₁₋ₓAs epitaxy layer concludes as shown in figure 9. It is ideal that the doping of Se into epitaxy layer is completely finalized at this stage, but practically H₂Se remains to be doped into the epitaxy layer based on H₂Se molecules which have attached to the internal wall of reaction tube or gas inlet tube. This results in a carrier concentration profile shown in figure 9. Such a phenomenon is called as "H₂Se memory effect".

A laser doublehetero (hereinafter referred to as "DH") wafer of figure 10 can be produced with using H₂Se as n type dopant as will be described below.

In figure 10, reference numeral 10 designates an n-GaAs substrate. An n-AlₓGa₁₋ₓAs first cladding layer 11 is grown on the substrate 10. A p-Al_{y}Ga_{1-y}As active layer 12 is grown on the first cladding layer 11. A p-AlₓGa₁₋ₓAs second cladding layer 13 is grown on the active layer 12. A p-GaAs contact layer 14 is grown on the second cladding layer 13. A pn junction is produced between the n-AlₓGa₁₋ₓAs first cladding layer 11 and the p-Al_{y}Ga_{1-y}As active layer 12. When this device is used for a CD laser, the n-AlₓGa₁₋ₓAs first cladding layer 11 with x = 0.5 having a film thickness of about 2.5um (microns), the p-Al_{y}Ga_{1-y}As active layer 12 with y = 0.15 having a film thickness of about 80nm (800 angstroms), the p-AlₓGa₁₋ₓAs second cladding layer 13 with x = 0.5 having a film thickness of about 1.2um (microns), and the p-GaAs contact layer 14 having a film thickness of about 0.5um (microns), are preferably employed.

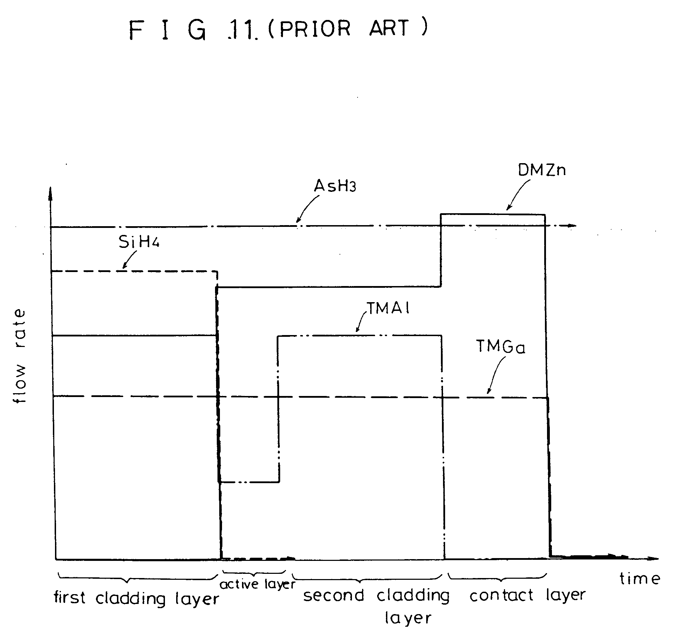

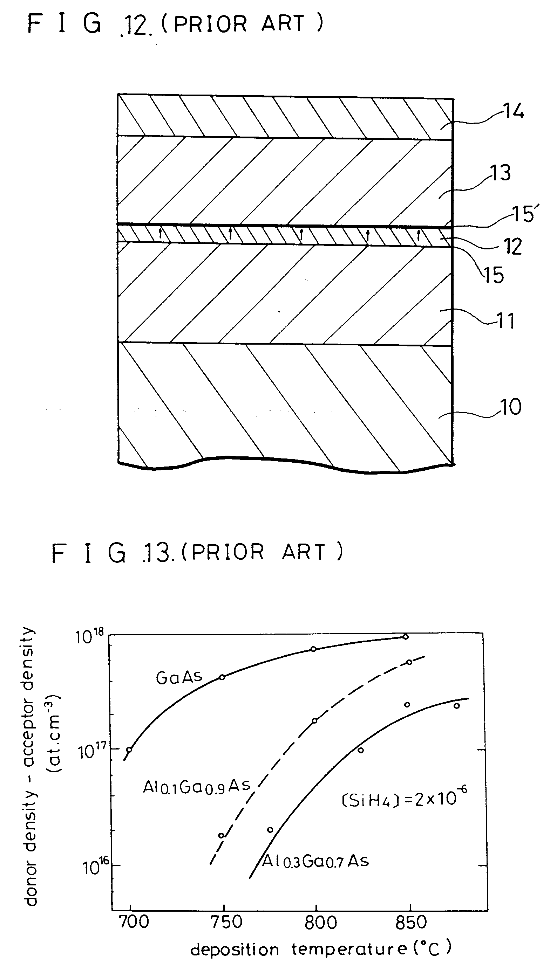

Figure 11 shows a growth program of MOCVD method which is conducted for obtaining the DH wafer shown in figure 10 with using the prior art semiconductor thin film crystal growth apparatus shown in figure 8. As shown in figure 11, when the growth of n-AlₓGa₁₋ₓAs first cladding layer 11 concludes, the supply of H₂Se is halted and the supply of DMZn is started. When such growth program is used, the position of pn junction 15′ is often deviated from the presupposed portion 15 toward the p-AlₓGa₁₋ₓAs second cladding layer 13 due to the above-described H₂Se memory effect, as shown in figure 12. Then, the width of positional deviation of pn junction varies dependent on the state of apparatus, more concretely, the state of internal wall of reaction tube or that of gas inlet tube.

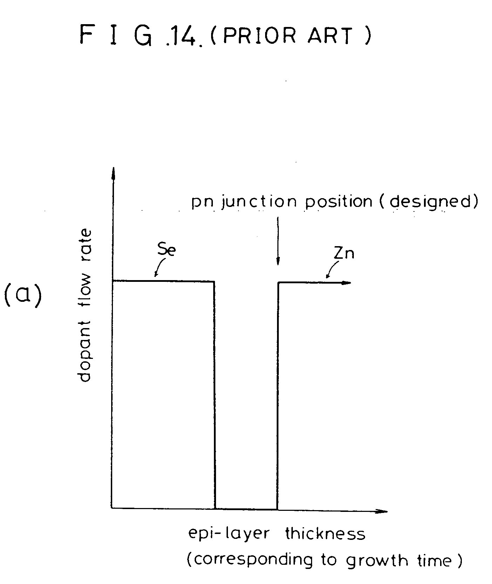

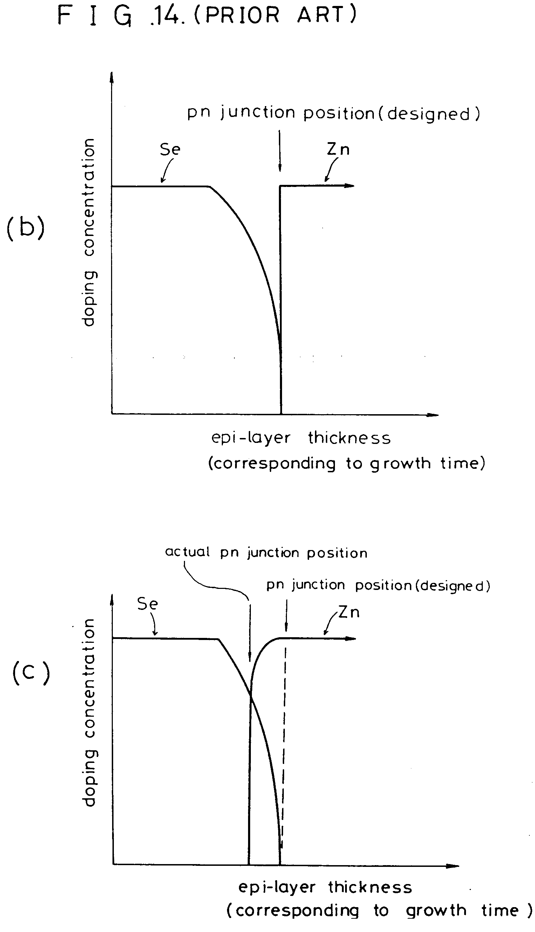

In order to prevent such positional deviation of pn junction, the supply of H₂Se is halted before Se reaches the design position of pn junction as shown in figure 14(a). Then, the doping of Se concludes at the pn junction design position in view of the H₂Se memory effect, as shown in figure 14(b). In this method, however, when the wafer is at high temperature in the later thermal annealing process, Zn as the p type dopant for producing the p-Al_{y}Ga_{1-y}As active layer 12 is diffused up to the n-AlₓGa₁₋ₓAs first cladding layer 11 provided therebelow, and the actual pn junction position is deviated from the design position toward the first cladding layer 11. Particularly, since Zn is diffused with a steeper profile than other dopant, the control of pn junction position is difficult. In case of CD laser, because the active layer generally has a rather thin film thickness of about 50 to 100nm (500 to 1000 angstroms), even when the pn junction position is slightly deviated from the design position (it is called as a "remote junction"), the laser characteristics deteriorates to a great extent.

In order to prevent the generation of remote junction due to the H₂Se memory effect, dopant material having a low memory effect is required. SiH₄ is well known as such dopant material. However, as shown in figure 13, SiH₄ has a disadvantage of low doping efficiency at the usual epitaxy growth temperature of about 600 to 750 °C. This is because the doping efficiency of SiH₄ is mainly regulated by its thermal decomposition speed. Since a high concentration doping up to about 1 × 10¹⁷ to 1 × 10 ¹⁹ cm ⁻³ is required to produce a semiconductor laser, it is difficult to produce an epitaxy layer for a semiconductor laser by using SiH₄ as doping material in MOCVD method.

Japanese Journal of Applied Physics, Vol. 26, No. 3, March 1987, pp L200-L202, refers to a method of enhancing doping efficiency by irradiating with ultraviolet radiation a reagent gas and a doping gas.

Problems in the prior art semiconductor thin film crystal growth by MOCVD method and the apparatus therefor are summarized as follows.
(1) In a case where H₂Se is used as dopant material, when the supply of dopant material into reaction tube is halted, the doping of Se into epitaxy layer would not immediately stop. Therefore, a steep doping profile cannot be obtained. Furthermore, as is easily presumed from this fact, an accurate control of the pn junction position is difficult.
(2) When SiH₄ having a low memory effect is used as dopant material, the doping efficiency is regulated by the thermal decomposition speed of the dopant, and a high concentration doping cannot be conducted at a practical crystal growth temperature.

### SUMMARY OF THE INVENTION

It is an object of the present invention to provide a method of crystal growing a semiconductor thin film by MOCVD method. Such a method may be capable of conducting a high concentration doping by using dopant material having a low memory effect, such as SiH₄, and may be capable of obtaining a steep doping profile.

Other features and advantages of the present invention will become apparent from the detailed description given hereafter; it should be understood, however, that the detailed description and specific embodiment are given by way of illustration only.

According to a first aspect of the present invention, there is provided a method of growing a crystalline semiconductor thin film on a substrate by metal organic chemical vapour deposition using reagent gases and a doping gas which provides the thin film with a carrier concentration which is regulated by the decomposition speed of the doping gas, the method comprising the steps of exposing the reagent gases and doping gas to the substrate or a transition layer produced thereon, and irradiating the doping gas with ultraviolet radiation to increase the decomposition speed of the doping gas, characterised in that the irradiation of the doping gas occurs prior to mixing with the reagent gases, thereby preventing undesired crystal growth rate change in the thin film.

According to a second aspect of the present invention, there is provided a method of growing a crystalline multi-layer semiconductor thin film including a pn junction by a metal organic chemical vapour deposition method, which comprises steps of: conducting a doping at a portion apart from the pn junction, of at least an n side of the junction, using a first doping gas which provides the thin film with a carrier concentration which is regulated by the transportation speed of the doping gas; conducting a doping at the neighborhood of the pn junction using a second doping gas which provides the thin film with a carrier concentration which is regulated by the decomposition speed of the doping gas, and reagent gases; and selectively irradiating the second of the doping gases with ultraviolet radiation prior to mixing with the reagent gas, thereby preventing undesired crystal growth rate change in the thin film.

According to a third aspect of the present invention, there is provided a crystal growth apparatus for growing a semiconductor thin film utilizing a metal organic chemical vapor deposition method, comprising: a first gas inlet for introducing material comprising alkyl group or hydride, doping gas and a carrier gas such as hydrogen into a reaction tube; characterised in that the doping gas introduced by the first gas inlet provides the thin film with a carrier concentration which is regulated by the transportation speed of the doping gas, and the apparatus further comprises a second gas inlet for introducing another doping gas, which provides the thin film with a carrier concentration which is regulated by the decomposition speed of the another doping gas into the reaction tube, which second gas inlet is constituted in a tube configuration and is made of a material such as quartz which allows the transmission of ultraviolet rays therein but confines the ultraviolet rays to the material except at an internal wall portion of the second gas inlet on which is provided a plurality of convex portions, concave portions, or portions having different refractive indices so that the ultraviolet rays leak out to the inside of the second gas inlet at those portions.

### BRIEF DESCRIPTION OF THE DRAWINGS

Figure 1 is a diagram showing doping characteristics according to a method of crystal growing a semiconductor thin film as a first embodiment of the present invention;
Figure 2 is a diagram showing a growth program of semiconductor laser DH wafer of figure 10 according to the first embodiment;
Figure 3 is a diagram showing doping characteristics according to a method of crystal growing a semiconductor thin film as a second embodiment of the present invention;
Figure 4 is a diagram showing doping characteristics according to a method of crystal growing a semiconductor thin film as a third embodiment of the present invention;
Figure 5 is a diagram showing a doping profile while producing a pn junction according to a method of crystal growing a semiconductor thin film as a fourth embodiment of the present invention;
Figure 6 is a diagram showing a doping profile of pn junction produced by the fourth embodiment;
Figure 7 is a diagram showing a cross-section of a crystal growth apparatus of a semiconductor thin film according to the present invention;
Figure 8 is a diagram showing a cross-section of a prior art MOCVD apparatus;
Figure 9 is a diagram showing doping characteristics of selenium according to a prior art;
Figure 10 is a diagram showing a cross-section of a semiconductor laser DH wafer according to the present invention and the prior art;
Figure 11 is a diagram showing a growth program of semiconductor DH wafer of figure 10 according to the prior art;
Figure 12 is a diagram showing an example of semiconductor laser DH wafer arising a remote junction according to the prior art;
Figure 13 is a diagram showing a doping characteristics of SiH₄ according to the prior art; and
Figures 14(a) to (c) are diagrams for explaining the causes of arising remote junction according to the prior art.

### DETAILED DESCRIPTION OF THE PREFERRED EMBODIMENTS

A method of crystal growing a semiconductor thin film according to a first embodiment of the present invention will be described as follows.

Herein, a case where an AlGaAs layer is epitaxy grown on a GaAs substrate will be described. The same materials, TMGa, TMAl, and AsH₃, as in the prior art method, are used. SiH₄ is used as a dopant whose carrier concentration is regulated by its decomposition speed. When SiH₄ is used, a steep carrier profile can be obtained because the SiH₄ memory effect is smaller than that of H₂Se which has been formerly used. However, in the prior art doping method using SiH₄, the doping efficiency was low and high concentration doping was difficult. This is because the doping speed of SiH₄ is regulated by its thermal decomposition speed.

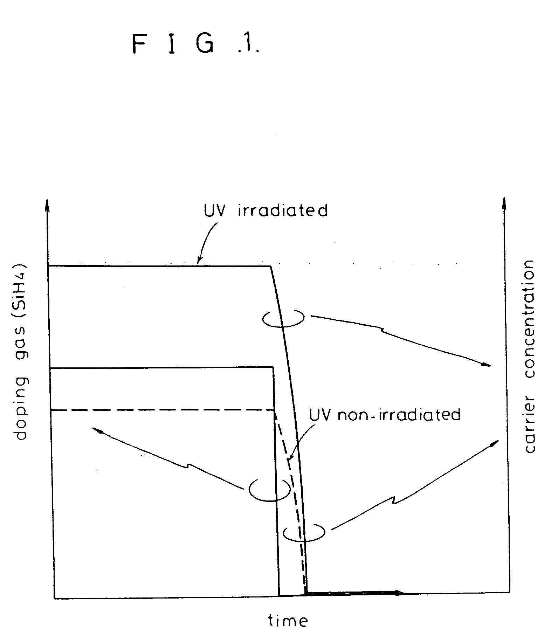

In this embodiment method, ultraviolet rays are irradiated to SiH₄ to increase the decomposition speed of SiH₄. For example, when excimer laser of 193 nm wavelength is irradiated to SiH₄, SiH₄ is excited and has a sufficiently high decomposition speed even at a low temperature of about 400 °C. Accordingly, at a growth temperature of 600 to 750 °C in ordinary MOCVD method, SiH₄ to which ultraviolet rays are irradiated acquires a sufficiently high thermal decomposition speed. Therefore, by increasing the supply amount of SiH₄, high concentration doping of above 1 × 10¹⁸ cm⁻³ is realized. Figure 1 shows the difference in the carrier concentrations between a case where ultraviolet rays are irradiated to SiH₄ and a case where they are not irradiated. The flow rate of SiH₄ is the same in both cases.

Furthermore, in this crystal growth method, since ultraviolet rays are selectively irradiated to SiH₄, materials such as TMGa, TMAl, and AsH₃ will not be excited by the ultraviolet rays. Therefore, it is possible to avoid variations in the composition ratio and the crystal growth speed due to variations in the decomposition speed arising when ultraviolet rays are irradiated to the materials.

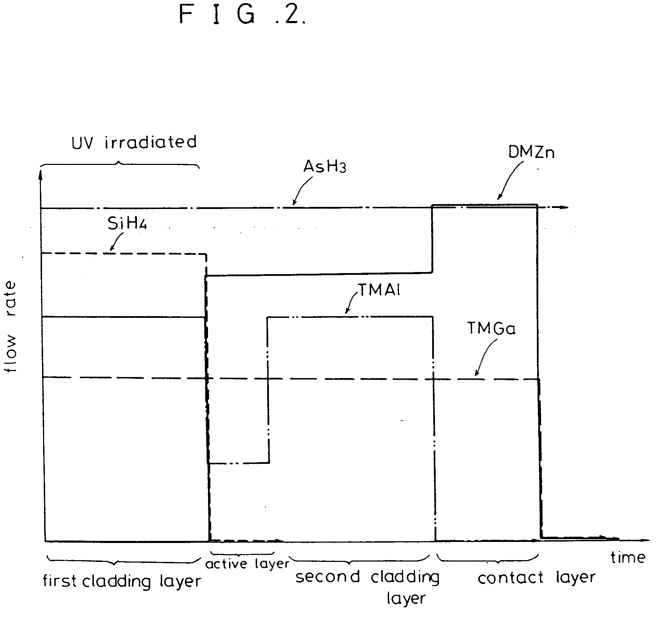

A semiconductor laser DH wafer of figure 10 can be produced by the method of this embodiment as will be described below. Figure 2 shows a growth program in this case. While conducting a crystal growth of n-AlₓGa₁₋ₓAs first cladding layer 11 on the n-GaAs substrate 10, SiH₄ is used as dopant and ultraviolet rays are selectively irradiated only to SiH₄ in order to realize a high concentration doping. The irradiation of ultraviolet rays and supply of SiH₄ are halted when growth of first cladding layer 11 concludes. In the DH wafer produced by this method, since the SiH₄ memory effect is low, the pn junction position will not deviate from the design position toward the second cladding layer 13. Furthermore, since the decomposition speed of SiH₄ can be sufficiently increased by the irradiation of ultraviolet rays, a high concentration doping of about 1 × 10¹⁸ cm⁻³ which is necessary for producing the laser DH crystal can be realized.

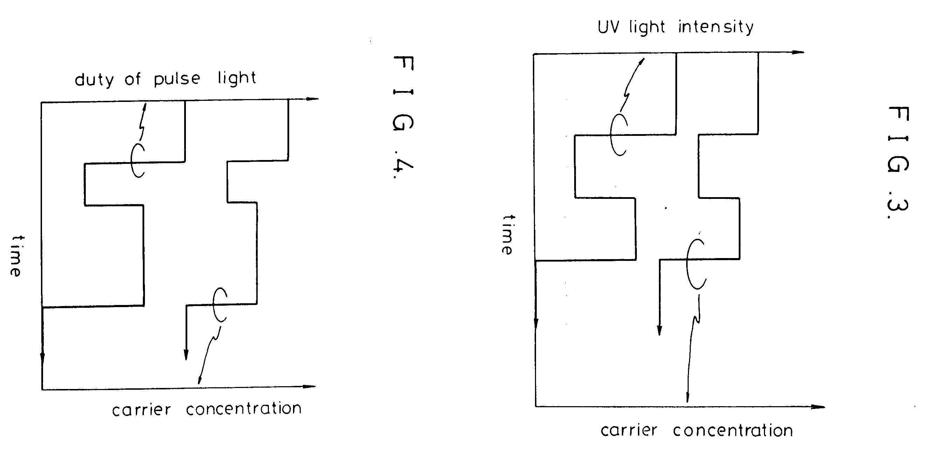

A second embodiment of the present invention for conducting crystal growth of semiconductor thin film will be described. Herein, SiH₄ is used as dopant as in the first embodiment. The decomposition speed of SiH₄ in the substrate or the transition region produced thereon to which ultraviolet rays are irradiated varies dependent on the intensity of the irradiated ultraviolet rays. Accordingly, by keeping the flow rate of SiH₄ constant and varying the light intensity of ultraviolet rays, the carrier concentration in the epitaxy layer can be varied (refer to figure 3). The carrier concentration in the epitaxy layer is controlled ordinarily by varying the flow rate of dopant. In this method, however, the apparatus therefor should be designed so that turbulences should not arise in the supply tube system and the manifold valve in order to obtain a steep doping profile.

In this embodiment method, since the doping rate can be controlled only by varying the light intensity without varying the flow rate of dopant, a steep doping profile can be obtained even in an MOCVD apparatus having a gas supply tube system which is not optimally designed.

A third embodiment of the present invention for conducting crystal growth of semiconductor thin film will be described. In this embodiment, SiH₄ is used as dopant as in the first embodiment. When ultraviolet rays pulses are irradiated to SiH₄, the pulse frequency is above several tens Hz, and the excitation rate of SiH₄ is controlled by varying the pulse duty, and as a result, the carrier concentration can be varied (refer to figure 4).

As sources of ultraviolet rays which are irradiated to dopants, a variety of sources may be raised. An excimer laser of 193 nm wavelength is optimum in view of irradiation light intensity and easiness in treatment. However, since the excimer laser has difficulty in accurately varying its output light intensity in short time, it is inadequate for a light source in the second embodiment method. However, pulse lights can be obtained by oscillating the excimer laser at continuous wave and introducing the laser lights into A/O modulator. Pulse lights of 193 nm wavelength having different pulse duty can be easily obtained by varying the pulse duty of voltage applied to the A/O modulator. In other words, the doping profile in the epitaxy layer can be controlled by varying the pulse duty of voltage applied to the A/O modulator.

A fourth embodiment of the present invention for conducting crystal growth of semiconductor thin film will be described. When epitaxy growth is conducted with using VI group material such as Se as a dopant, the carrier concentration and the photo luminescence intensity (hereinafter referred to as "PL intensity") hardly depend on the growth condition. On the contrary, since Si is an amphoteric impurity in the III - V compound, the carrier concentration is varied in accordance with the crystal growth condition (V/III ratio), and the PL intensity of epitaxy layer greatly depends on the growth condition. Especially in a case of high doping, deep levels can be easily produced in the substrate. When such deep levels exist, the PL intensity in the crystal is lowered. When a crystal having low PL intensity is used as laser crystal, the light emission efficiency is unfavorably deteriorated. Therefore, while there arises no problem when doping rate is about 1 × 10¹⁸ cm⁻³ as usual, the doping level of SiH₄ has to be carefully selected when doping rate is above 3 × 10¹⁸ cm⁻³.

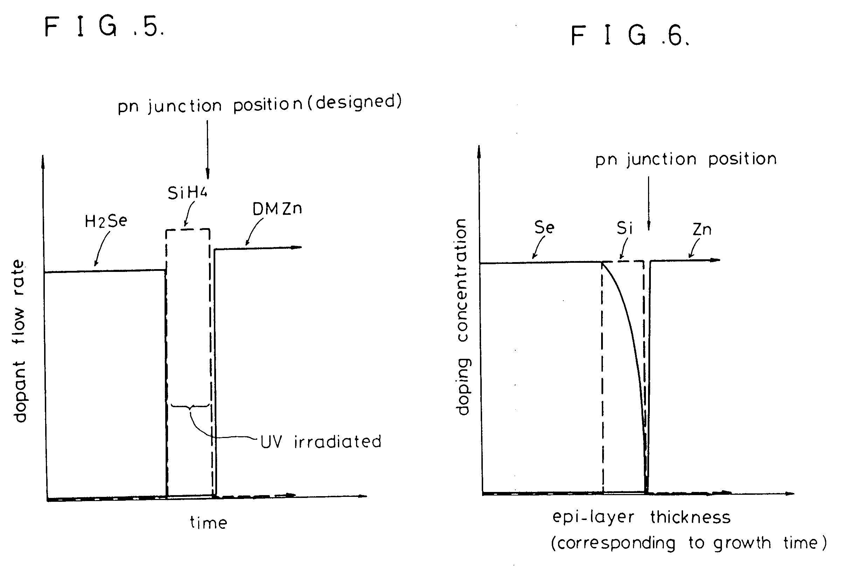

However, when H₂Se having less crystal growth condition dependency as such is used as doping gas, there may arise problem of remote junction that the pn junction position is deviated. Therefore, in view of above-described problems, especially when this embodiment method is employed for producing a high light emission efficiency and high power laser device, crystal growth is conducted with using H₂Se as dopant at n side region apart from the pn junction thereby producing an epitaxial layer having a stability of optical characteristics, and then, the n type dopant is switched to SiH₄ when the doping proceeds up to the neighborhood of pn junction, and at the same time ultraviolet rays are selectively irradiated only to SiH₄. Then, the supply of SiH₄ is halted when the growth of n type layer concludes, and supply of DMZn which is p type dopant is started. The flow chart of this growth program is shown in figure 5.

The doping concentrations of respective impurities in the epitaxy layer produced by this method are shown in figure 6. When the supply of gas is halted, the doping of Se slowly decreases due to the memory effect. Meanwhile, the dopant Se is switched to Si. The doping material of Si is SiH₄, and a high concentration doping that is approximately equal to that obtained by using H₂Se is realized by irradiating ultraviolet rays to SiH₄. When the growth of n type layer concludes, the supply of SiH₄ is halted, and then the doping of Si rapidly falls down because the SiH₄ memory effect is low. Therefore, no remote junction is likely to occur. Furthermore, since the n type layers are doped by using Se which is optically stable, except a region near the pn junction, the optical characteristics of epitaxy layers are kept in a good state. As described above, in this embodiment method, a high doped region having a doping concentration of about 3 × 10¹⁸ cm⁻³ is produced by doping H₂Se at a region deeper than pn junction 15 and doping of SiH₄ at doping concentration of 1 × 10¹⁸ cm⁻³ is conducted at the neighborhood of pn junction 15, thereby producing a pn junction at a design position. This method is quite effective for producing a high output laser device.

While in the above-described first to fourth embodiments, SiH₄ is used as n type doping material whose carrier concentration is regulated by its decomposition speed, organic substances of Si or GeH₄ may also be used.

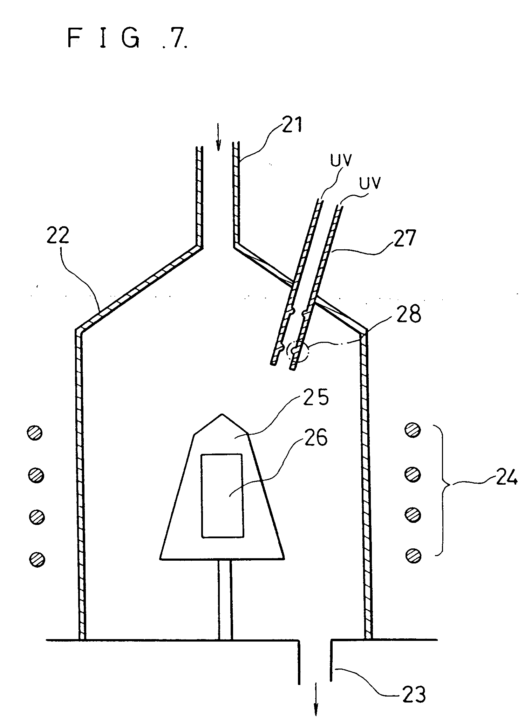

Figure 7 shows a crystal growth apparatus for growing semiconductor thin films according to a fifth embodiment of the present invention.

In figure 7, reference numeral 22 designates a reaction tube having a gas inlet at the top portion thereof. Materials comprising alkyl group or hydride, doping material whose carrier concentration is regulated by its transportation speed, and carrier gas such as hydrogen are introduced into the reaction tube 22 from the gas inlet 21. A gas outlet 23 for exhausting the gas to the outside is provided at the bottom of reaction tube 22. A carbon susceptor 25 for holding and heating a growth wafer 26 is provided inside the reaction tube 22. RF coils 24 for induction heating the susceptor 25 at high frequency are provided outside the reaction tube 22 with surrounding the same. A dopant inlet 27 for introducing doping material whose carrier concentration is regulated by its decomposition speed into the reaction tube 22. This dopant inlet 27 is constituted in a tube configuration and is made of material such as quartz which is transparent to ultraviolet rays, wherein the ultraviolet rays transmit confined in the transparent material constituting the dopant inlet 27. A plurality of convex portions 28 are provided at the internal wall of dopant inlet 27 so that the ultraviolet rays leak out to the inside of tube 22 at those portions.

In this apparatus, dopant material such as SiH₄ whose carrier concentration is regulated by the decomposition speed is introduced into the reaction tube 22 from the dopant inlet 27. The SiH₄ gas is excited by the ultraviolet rays which leak out from the convex portions 28 while introduced through the dopant inlet 27. This excited SiH₄ gas is decomposed on the heated growth wafer 26 at a sufficiently large decomposition speed. Furthermore, in this apparatus, the ultraviolet rays transmit confined in the transparent material of dopant inlet 27 which is constituted by the transparent material such as quartz in a tube configuration. The ultraviolet rays leak out to the inside of tube 22 only at the convex portions 28 which are provided at the internal wall of dopant inlet 27. Therefore, the ultraviolet rays can be selectively irradiated only to SiH₄.

While in the above-illustrated embodiment, a plurality of convex portions 28 are provided at the internal wall of dopant inlet 27 so that the ultraviolet rays-leak out to the inside of reaction tube thereat, concave portions or portions having different refractive indices may be provided with the same effect as described above.

According to the crystal growth apparatus of this embodiment, since ultraviolet rays are selectively irradiated only to SiH₄, only SiH₄ can be excited while the material such as TMGa are not excited. Therefore, the doping efficiency can be enhanced without causing no variation of growth speed which would occur when the ultraviolet rays are irradiated to the entire material gas.

As is evident from the foregoing description, according to the first embodiment of the present invention, while doping is conducted with using a dopant whose carrier concentration is regulated by its decomposition speed in the MOCVD method, ultraviolet rays are selectively irradiated only to the dopant before the dopant reaches a substrate or a transition layer produced on the substrate. Therefore, a high concentration doping and a steep doping profile can be realized.

According to the second embodiment of the present invention, while ultraviolet rays are selectively irradiated only to the dopant before the dopant reaches the substrate or the transition layer produced on the substrate, the light intensity of ultraviolet rays is controlled without varying the flow rate of dopant, thereby varying the doping profile.

According to the third embodiment of the present invention, while ultraviolet rays are selectively irradiated only to the dopant before the dopant reaches the substrate or the transition layer produced on the substrate, ultraviolet rays of pulse lights having constant peak intensity are adopted, and the pulse frequency is controlled by the pulse width. Therefore, the pulse width and the pulse frequency are controlled without varying the flow rate of dopant, thereby varying the doping profile.

According to the fourth embodiment of the present invention, while a multi-layer semiconductor thin film including a pn junction is crystal grown by MOCVD method, a doping at a region apart from the pn junction, of at least at n side is conducted by using dopant whose carrier concentration is regulated by its transportation speed, and the doping at the neighborhood of pn junction is conducted by using dopant whose carrier concentration is regulated by its decomposition speed, and ultraviolet rays are selectively irradiated only to the dopant before the dopant reaches the substrate or the transition layer produced on the substrate. Therefore, a multi-layer semiconductor thin film crystal having a stability of optical characteristics and having no remote junction can be obtained.

According to a crystal growth apparatus for growing a semiconductor thin film of the present invention, a crystal growth apparatus used for MOCVD method has a first gas inlet which introduces material comprising alkyl group or hydride, doping material whose carrier concentration is regulated by its transportation speed, and carrier gas such as hydrogen into a reaction tube, and a second gas inlet which introduces doping material whose carrier concentration is regulated by its decomposition speed into the reaction tube. The second gas inlet is constituted in a tube configuration and is made of a material transparent to ultraviolet rays such as quartz so that ultraviolet rays transmit confined in the transparent material. A plurality of convex portions, concave portions, or portions having different refractive indices are provided at the internal wall of second gas inlet so that ultraviolet rays leak out to the inside of tube from the portions. Therefore, ultraviolet rays can be selectively irradiated only to the dopant material whose carrier concentration is regulated by its decomposition speed.

## Claims

1. A method of growing a crystalline semiconductor thin film on a substrate by metal organic chemical vapour deposition using reagent gases and a doping gas which provides said thin film with a carrier concentration which is regulated by the decomposition speed of said doping gas, the method comprising the steps of exposing said reagent gases and doping gas to said substrate or a transition layer produced thereon, and irradiating said doping gas with ultraviolet radiation to increase the decomposition speed of said doping gas, characterised in that said irradiation of said doping gas occurs prior to mixing with said reagent gases, thereby preventing undesired crystal growth rate change in said thin film.

2. A method of growing a crystalline semiconductor thin film as defined in claim 1, wherein said doping gas is SiH₄.

3. A method of growing a crystalline semiconductor thin film as defined in claim 1, wherein said doping gas is organic matter of silicon.

4. A method of growing a crystalline semiconductor thin film as defined in claim 1, wherein said doping gas is GeH₄.

5. A method of growing a crystalline semiconductor thin film as defined in claim 1, wherein the decomposition speed of said doping gas is controlled by varying the light intensity of said ultraviolet radiation without changing the flow rate of said doping gas.

6. A method of growing a crystalline semiconductor thin film as defined in claim 1, wherein said ultraviolet radiation is applied to said doping gas in a series of pulses having a constant peak intensity without changing the flow rate of said doping gas, and the carrier concentration of said thin film is controlled by varying the pulse width and pulse frequency of said ultraviolet radiation.

7. A method of growing a crystalline multi-layer semiconductor thin film including a pn junction by a metal organic chemical vapour deposition method, which comprises steps of:
conducting a doping at a portion apart from said pn junction, of at least the n side of said junction, using a first doping gas which provides said thin film with a carrier concentration which is regulated by the transportation speed of the doping gas;
conducting a doping at the neighborhood of said pn junction using a second doping gas which provides said thin film with a carrier concentration which is regulated by the decomposition speed of the doping gas, and reagent gases; and
selectively irradiating the second of said doping gases with ultraviolet radiation prior to mixing with said reagent gas, thereby preventing undesired crystal growth rate change in said thin film.

8. A method of growing a crystalline multi-layer semiconductor thin film including a pn junction as defined in claim 7, wherein said second doping gas which provides said thin film with a carrier concentration which is regulated by its decomposition speed is SiH₄.

9. A method of growing a crystalline multi-layer semiconductor thin film including a pn junction as defined in claim 7, wherein said second doping gas which provides said thin film with a carrier concentration which is regulated by its decomposition speed is organic matter of silicon.

10. A method of crystal growing a multi-layer semiconductor thin film including a pn junction as defined in claim 7, wherein said second doping gas which provides said thin film with a concentration which is regulated by its decomposition speed is GeH₄.

11. A method of growing a crystalline multi-layer semiconductor thin film including a pn junction as defined in claim 7, wherein said first doping gas which provides said thin film with a carrier concentration which is regulated by its transportation speed is H₂Se.

12. A method of growing a crystalline multi-layer semiconductor thin film including a pn junction as defined in claim 7, wherein said doping conducted at said portion apart from said pn junction is a high concentration doping and said doping conducted at the neighborhood of said pn junction is a low concentration doping, while producing a double-hetero wafer for a semiconductor laser device.

13. A method of growing a crystalline multi-layer semiconductor thin film including a pn junction as defined in claim 12, wherein said high concentration doping is conducted at the impurity concentration of 3 x 10¹⁸ cm⁻³ and said low concentration doping is conducted at the impurity concentration of 1 x 10¹⁸ cm⁻³.

14. A crystal growth apparatus for growing a semiconductor thin film utilizing a metal organic chemical vapor deposition method, comprising:
a first gas inlet (21) for introducing material comprising alkyl group or hydride, doping gas and a carrier gas such as hydrogen into a reaction tube (22);
characterised in that said doping gas introduced by said first gas inlet (21) provides said thin film with a carrier concentration which is regulated by the transportation speed of said doping gas, and the apparatus further comprises a second gas inlet (27) for introducing another doping gas, which provides said thin film with a carrier concentration which is regulated by the decomposition speed of said another doping gas into said reaction tube (22), which second gas inlet (27) is constituted in a tube configuration and is made of a material such as quartz which allows the transmission of ultraviolet rays therein but confines said ultraviolet rays to said material except at an internal wall portion of said second gas inlet (27) on which is provided a plurality of convex portions, concave portions, or portions having different refractive indices (28) so that said ultraviolet rays leak out to the inside of said second gas inlet (27) at those portions (28).

## Patentansprüche

1. Verfahren zum Wachsen eines kristallinen Halbleiter-Dünnfilms auf einem Substrat durch metallorganische Dampfphasenbeschichtung unter Verwendung von Reaktionsmittel-Gasen und einem Dotiergas, das den Dünnfilm mit einer Ladungsträgerkonzentration ausstattet, die durch die Zersetzungsgeschwindigkeit des Dotiergases eingestellt wird, wobei das Verfahren die folgenden Schritte umfaßt: Das Substrat oder eine auf dem Substrat erzeugte Übergangsschicht werden den Reaktionsmittel-Gasen und dem Dotiergas ausgesetzt, und das Dotiergas wird mit ultravioletter Strahlung bestrahlt, um die Zersetzungsgeschwindigkeit des Dotiergases zu erhöhen, dadurch gekennzeichnet, daß die Bestrahlung des Dotiergases vor dem Mischen mit den Reaktionsmittel-Gasen stattfindet, wodurch eine unerwünschte Veränderung der Kristallwachstumsrate in dem Dünnfilm verhindert wird.

2. Verfahren zum Wachsen eines kristallinen Halbleiter-Dünnfilms nach Anspruch 1, wobei das Dotiergas SiH₄ ist.

3. Verfahren zum Wachsen eines kristallinen Halbleiter-Dünnfilms nach Anspruch 1, wobei das Dotiergas organische Siliziumsubstanz ist.

4. Verfahren zum Wachsen eines kristallinen Halbleiter-Dünnfilms nach Anspruch 1, wobei das Dotiergas GeH₄ ist.

5. Verfahren zum Wachsen eines kristallinen Halbleiter-Dünnfilms nach Anspruch 1, wobei die Zersetzungsgeschwindigkeit des Dotiergases gesteuert wird, indem die Lichtintensität der ultravioletten Strahlung variiert wird, ohne die Flußrate des Dotiergases zu verändern.

6. Verfahren zum Wachsen eines kristallinen Halbleiter-Dünnfilms nach Anspruch 1, wobei die ultraviolette Strahlung dem Dotiergas in einer Reihe von Pulsen mit einer konstanten Peak-Intensität zugeführt wird, ohne die Flußrate des Dotiergases zu verändern, und die Ladungsträgerkonzentration des Dünnfilms gesteuert wird, indem die Pulsbreite und Pulsfrequenz der ultravioletten Strahlung variiert werden.

7. Verfahren zum Wachsen eines kristallinen Vielschicht-Halbleiter-Dünnfilms mit einem pn-Übergang durch ein metallorganisches Dampfphasenbeschichtungsverfahren, das folgende Schritte umfaßt:
Durchführen einer Dotierung an einem Bereich abseits von dem pn-Übergang, von mindestens der n-Seite des Übergangs unter Verwendung eines ersten Dotiergases, das den Dünnfilm mit einer Ladungsträgerkonzentration ausstattet, die durch die Transportgeschwindigkeit des Dotiergases eingestellt wird;
Durchführen einer Dotierung in der Nähe des pn-Übergangs unter Verwendung eines zweiten Dotiergases, das den Dünnfilm mit einer Ladungsträgerkonzentration ausstattet, die durch die Zersetzungsgeschwindigkeit des Dotiergases eingestellt wird, und von Reaktionsmittel-Gasen; und
selektives Bestrahlen des zweiten der Dotiergase mit ultravioletter Strahlung vor dem Vermischen mit dem Reaktionsmittel-Gas, wodurch unerwünschte Veränderung der Kristallwachstumsrate in dem Dünnfilm verhindert wird.

8. Verfahren zum Wachsen eines kristallinen Vielschicht-Halbleiter-Dünnfilms mit einem pn-Übergang nach Anspruch 7, wobei das zweite Dotiergas, das den Dünnfilm mit einer Ladungsträgerkonzentration ausstattet, die durch seine Zersetzungsgeschwindigkeit eingestellt wird, SiH₄ ist.

9. Verfahren zum Wachsen eines kristallinen Vielschicht-Halbleiter-Dünnfilms mit einem pn-Übergang nach Anspruch 7, wobei das zweite Dotiergas, das den Dünnfilm mit einer Ladungsträgerkonzentration ausstattet, die durch seine Zersetzungsgeschwindigkeit eingestellt wird, organische Siliziumsubstanz ist.

10. Verfahren zum Kristallwachsen eines Vielschicht-Halbleiter-Dünnfilms mit einem pn-Übergang nach Anspruch 7, wobei das zweite Dotiergas, das den Dünnfilm mit einer Konzentration ausstattet, die durch seine Zersetzungsgeschwindigkeit eingestellt wird, GeH₄ ist.

11. Verfahren zum Wachsen eines kristallinen Vielschicht-Halbleiter-Dünnfilms mit einem pn-Übergang nach Anspruch 7, wobei das erste Dotiergas, das den Dünnfilm mit einer Ladungsträgerkonzentration ausstattet, die durch seine Transportgeschwindigkeit eingestellt wird, H₂Se ist.

12. Verfahren zum Wachsen eines kristallinen Vielschicht-Halbleiter-Dünnfilms mit einem pn-Übergang nach Anspruch 7, wobei die Dotierung, die an dem Bereich abseits von dem pn-Übergang durchgeführt wird, eine Dotierung mit hoher Konzentration ist und die Dotierung, die in der Nähe des pn-Übergangs durchgeführt wird, eine Dotierung mit niedriger Konzentration ist, während ein Doppelhetero-Wafer für eine Halbleiter-Laservorrichtung hergestellt wird.

13. Verfahren zum Wachsen eines kristallinen Vielschicht-Halbleiter-Dünnfilms mit einem pn-Übergang nach Anspruch 12, wobei die Dotierung mit hoher Konzentration bei der Verunreinigungs-Konzentration von 3 x 10¹⁸ cm⁻³ und die Dotierung mit niedriger Konzentration bei der Verunreinigungs-Konzentration von 1 x 10¹⁸ cm⁻³ durchgeführt wird.

14. Kristallwachstumsvorrichtung zum Wachsen eines Halbleiter-Dünnfilms unter Verwendung eines Verfahrens zur metallorganischen Dampfphasenbeschichtung, umfassend:
eine erste Gas-Einlaßöffnung (21) zum Einleiten von Alkylgruppe oder Hydrid umfassendem Material, Dotiergas und einem Trägergas wie Wasserstoff in eine Reaktionsröhre (22);
dadurch gekennzeichnet, daß das durch die erste Gas-Einlaßöffnung (21) eingeleitete Dotiergas den Dünnfilm mit einer Ladungsträgerkonzentration ausstattet, die durch die Transportgeschwindigkeit des Dotiergases eingestellt wird, und daß die Vorrichtung ferner eine zweite Gas-Einlaßöffnung (27) zum Einleiten eines weiteren Dotiergases in die Reaktionsröhre (22) umfaßt, das den Dünnfilm mit einer Ladungsträgerkonzentration ausstattet, die durch die Zersetzungsgeschwindigkeit des weiteren Dotiergases eingestellt wird, wobei die zweite Gas-Einlaßöffnung (27) in einer Röhrenkonstruktion aufgebaut ist und aus einem Material wie Quarz hergestellt ist, das die Transmission von Ultraviolett-Strahlen in die zweite Gas-Einlaßöffnung zuläßt, aber die Ultraviolett-Strahlen auf das Material begrenzt, außer an einem inneren Wandbereich der zweiten Gas-Einlaßöffnung (27), auf dem eine Vielzahl von konvexen Bereichen, konkaven Bereichen oder Bereichen mit unterschiedlichen Brechungsindizes (28) bereitgestellt ist, so daß die Ultraviolett-Strahlen an solchen Bereichen (28) zu der Innenseite der zweiten Gas-Einlaßöffnung (27) entweichen.

## Revendications

1. Un procédé de croissance d'une pellicule mince de semiconducteur cristallin sur un substrat, par dépôt chimique en phase vapeur aux organométalliques utilisant des gaz réactifs et un gaz de dopage qui donne à cette pellicule mince une concentration de porteurs qui est régulée par la vitesse de décomposition du gaz de dopage, le procédé comprenant les étapes qui consistent à exposer les gaz réactifs et le gaz de dopage au substrat ou à une couche de transition qui est formée sur celui-ci, et à irradier le gaz de dopage avec un rayonnement ultraviolet pour augmenter la vitesse de décomposition de ce gaz de dopage, caractérisé en ce que l'irradiation du gaz de dopage a lieu avant le mélange avec les gaz réactifs, pour empêcher ainsi un changement indésirable de la vitesse de croissance cristalline dans la pellicule mince.

2. Un procédé de croissance d'une pellicule mince de semiconducteur cristallin selon la revendication 1, dans lequel le gaz de dopage consiste en SiH₄.

3. Un procédé de croissance d'une pellicule mince de semiconducteur cristallin selon la revendication 1, dans lequel le gaz de dopage est un composé organique de silicium.

4. Un procédé de croissance d'une pellicule mince de semiconducteur cristallin selon la revendication 1, dans lequel le gaz de dopage consiste en GeH₄.

5. Un procédé de croissance d'une pellicule mince de semiconducteur cristallin selon la revendication 1, dans lequel on commande la vitesse de décomposition du gaz de dopage en faisant varier l'intensité lumineuse du rayonnement ultraviolet, sans changer le débit du gaz de dopage.

6. Un procédé de croissance d'une pellicule mince de semiconducteur cristallin selon la revendication 1, dans lequel le rayonnement ultraviolet est appliqué au gaz de dopage sous la forme d'une série d'impulsions ayant une intensité de crête constante, sans changer le débit du gaz de dopage, et on commande la concentration de porteurs de la pellicule mince en faisant varier la largeur des impulsions et la fréquence des impulsions du rayonnement ultraviolet.

7. Un procédé de croissance d'une pellicule mince de semiconducteur cristallin multicouche comprenant une jonction pn, par un procédé de dépôt chimique en phase vapeur aux organométalliques, comprenant les étapes suivantes :
on effectue un dopage dans une partie disjointe de la jonction pn, portant au moins sur le côté n de cette jonction, en utilisant un premier gaz de dopage qui donne à la pellicule mince une concentration de porteurs qui est régulée par la vitesse de transport du gaz de dopage;
on effectue un dopage au voisinage de la jonction pn en utilisant un second gaz de dopage qui donne à la pellicule mince une concentration de porteurs qui est régulée par la vitesse de décomposition du gaz de dopage, et des agents réactifs; et
on irradie sélectivement le second des gaz de dopage avec un rayonnement ultraviolet, avant le mélange avec les gaz réactifs, pour empêcher ainsi un changement indésirable de la vitesse de croissance cristalline dans la pellicule mince.

8. Un procédé de croissance d'une pellicule mince de semiconducteur cristallin multicouche, comprenant une jonction pn, selon la revendication 7, dans lequel le second gaz de dopage qui donne à la pellicule mince une concentration de porteurs qui est régulée par sa vitesse de décomposition, consiste en SiH₄.

9. Un procédé de croissance d'une pellicule mince de semiconducteur cristallin multicouche, comprenant une jonction pn, selon la revendication 7, dans lequel le second gaz de dopage qui donne à la pellicule mince une concentration de porteurs qui est régulée par sa vitesse de décomposition, est un composé organique de silicium.

10. Un procédé de croissance d'une pellicule mince de semiconducteur cristallin multicouche, comprenant une jonction pn, selon la revendication 7, dans lequel le second gaz de dopage qui donne à la pellicule mince une concentration qui est régulée par sa vitesse de décomposition, consiste en GeH₄.

11. Un procédé de croissance d'une pellicule mince de semiconducteur cristallin multicouche comprenant une jonction pn selon la revendication 7, dans lequel le premier gaz de dopage qui donne à la pellicule mince une concentration de porteurs qui est régulée par sa vitesse de transport, est H₂Se.

12. Un procédé de croissance d'une pellicule mince de semiconducteur cristallin multicouche comprenant une jonction pn selon la revendication 7, dans lequel le dopage qui est effectué dans la partie disjointe de la jonction pn est un dopage avec une concentration élevée, et le dopage qui est effectué au voisinage de la jonction pn est un dopage avec une faible concentration, dans le cadre de la formation d'une tranche à double hétérojonction pour un dispositif laser à semiconducteurs.

13. Un procédé de croissance d'une pellicule mince de semiconducteur cristallin multicouche comprenant une jonction pn selon la revendication 12, dans lequel le dopage avec une concentration élevée est effectué avec la concentration en impureté de 2 x 10¹⁸ cm⁻³, et le dopage à faible concentration est effectué avec la concentration en impureté de 1 x 10¹⁸ cm⁻³.

14. Un appareil de croissance cristalline pour faire croîte une pellicule mince de semiconducteur en utilisant un procédé de dépôt chimique en phase vapeur aux organométalliques, comprenant :
un premier orifice d'entrée de gaz (21) pour introduire dans un tube de réaction (22) une matière consistant en un groupe alkyle ou en un hydrure, un gaz de dopage et un gaz de transport;
caractérisé en ce que le gaz de dopage qui est introduit par le premier orifice d'entrée de gaz (21) produit la pellicule mince avec une concentration de porteurs qui est régulée par la vitesse de transport du gaz de dopage, et l'appareil comprend en outre un second orifice d'entrée de gaz (27) pour introduire dans le tube de réaction (22) un autre gaz de dopage, qui donne à la pellicule mince une concentration de porteurs qui est régulée par la vitesse de décomposition de cet autre gaz de dopage, le second orifice d'entrée de gaz (27) étant constitué par une configuration de tube et consistant en une matière telle que le quartz qui permet la transmission de rayons ultraviolets à l'intérieur mais confine les rayons ultraviolets à cette matière, sauf dans une partie de paroi interne du second orifice d'entrée de gaz (27) sur laquelle sont formées un ensemble de parties convexes, de parties concaves ou de parties ayant des indices de réfraction (28) différents, de façon que les rayons ultraviolets fuient vers l'intérieur du second orifice d'entrée de gaz (27) dans ces parties (28).
